# EUROPEAN PATENT SPECIFICATION

(11) **EP 1 546 681 B1**
(45) Date of publication and mention of the grant of the patent: **19.11.2008**
(21) Application number: 03784315.8
(22) Date of filing: 31.07.2003
(51) Int. Cl.: G01N 21/00, G01N 21/05, H01L 21/56, B01L 3/00

(54) **A METHOD OF MANUFACTURING INTEGRATED CIRCUIT SENSORS**
VERFAHREN ZUR HERSTELLUNG VON INTEGRIERTEN SCHALTUNGSSENSOREN
PROCEDE DE FABRICATION DE CAPTEURS SUR CIRCUITS INTEGRES

(30) Priority: 02.08.2002 GB 0217902
(43) Date of publication of application: 29.06.2005
(73) Proprietor: Melexis NV, 8900 Leper (BE)
(72) Inventor: BETTS, William Robert, Burntwood, Staffordshire WS7 8XA (GB); VERLINDEN, Steven, B-3200 Aarschot (BE)
(74) Representative: Church, Simon John
(86) International application number: PCT/IB2003/003057
(87) International publication number: WO 2004/015400

(56) References cited:
- EP-A- 1 211 722
- US-A- 5 904 955
- US-B1- 6 326 612

## Description

The present invention relates to encapsulation of integrated circuit sensors, and more particularly to low-cost encapsulation of biological and chemical sensor flow cells.

Biological and chemical sensors incorporated into integrated circuits have recently become more widely used and are used in particular to sense chemical compounds, living animals or biological contamination in the air. For example, typical uses for such sensors are in the detection of airborne pollutants, smuggled or concealed substances, humans or animals or hazardous substances which may be released or may escape into the atmosphere.

However it can be expensive to manufacture flow cells with biological and chemical sensors of this type since the mounting of the integrated circuit can be expensive due to the need to allow flow of material to be sensed across the sensor. The operating life of the sensing element also may be short due to contamination in use and require that the flow cell and sensing element are changed frequently. It will be appreciated that for these sensors to be widely used, flow cells containing such sensors must be relatively inexpensive to produce in quantity.

The present invention addresses this problem and has as its object a method of encapsulation of integrated circuit sensors in a flow cell which is relatively low-cost and due to this low cost the finished encapsulated biological and chemical sensor can be disposable.

Thus and in accordance with the first aspect of the present invention there is provided a method of encapsulating an integrated circuit sensor comprising the following steps: -
Providing an integrated circuit including a biological or chemical sensor;
Applying a gel material to said circuit so as to substantially cover at least said sensor
Inserting said integrated circuit into a cavity of a moulding tool;
Mounting two or more pins relative to said circuit such that said pins extend substantially into contact with said gel covering said sensor;
Introducing a mould compound into said cavity whereby said integrated circuit and a part of said pins are encapsulated thereby;
Removing said pins to form bores extending through said moulded material to said gel; and
Removing substantially all of said gel material from the sensor so as to expose the sensor to the atmosphere via said bore.

With this method it is possible to manufacture encapsulated integrated circuit flow sensors at relatively low-cost.

Preferably, the integrated circuit including the biological or chemical sensor is mounted on a metal carrier or paddle. The paddle may be formed as one piece or may in alternative embodiments comprise a plurality of electrically separate sections upon which additional integrated circuits may be mounted. The additional integrated circuits may include, for example, signal processing circuitry, power generation circuitry, power supply circuitry, signal transmission and reception circuitry or any other circuitry which is necessary to ensure the correct operation of the sensor for any particular application. Preferably, these additional integrated circuits may be encapsulated along with the integrated circuit including the biological or chemical sensor.

Electrical connections may be made to the or each integrated circuit by wire bonding between connection points on the respective integrated circuits and internal ends of metal pins that will form the external electrical connections to the encapsulated circuits when moulded. In embodiments wherein the paddle comprises a plurality of electrically separate sections, electrical connections may also be made between integrated circuits mounted on separate paddle sections by wire bonding between connecting points on the respective integrated circuits.

The gel may be removed from the biological or chemical sensor by any suitable method for instance, mechanically, by dissolving or washing away, or by being sucked off. The bores, together with the cavity formed by the removal z of the gel, define a flow passage in the plastic encapsulant after moulding, which allows for the flow of air or gas to pass across the surface of the sensor and thereby for biological or chemical matter in the air to be detected by the sensor.

The biological or chemical sensor may be a sensor of the type comprising an reactive substance provided on a integrated circuit, the reactive substance reacting with particular biological or chemical elements in the air, the reaction being detected by the integrated circuit and thus indicating the presence of the particular biological or chemical element. Such sensors may require activation before use by addition of an activating substance. Suitable activating substances include the reactive substance itself or catalysts which enable or speed up the reaction. In alternative embodiments, a protective layer may be provided over the reactive substance for protection during the encapsulation process. In such embodiments, activation of the sensor may be achieved by removing the projective layer, for instance by use of a solvent to dissolve or wash away the protective layer. Alternatively, the protective layer may be removed mechanically by any suitable means. Activation of such a sensor may be performed directly after the gel is removed from the bore or directly before the sensor is to be used or at any convenient time between these two events.

In some preferred embodiments, the biological or chemical sensor may be a sensor of the type which is designed to operate with an air or gas flow passing through one or more orifices in the sensor itself. Such sensors include micro-machined silicon integrated circuits that detect variations in speed of sound through a gaseous sample as an indication of the presence of contaminants.

In a further embodiment, the flow of air or gas may be arranged to be through a first bore in the encapsulant on a first side of the integrated circuit, through one or more orifices in the sensor, through an orifice in the paddle carrying the integrated circuit and through a second bore in the encapsulant on a second side of the integrated circuit. Such a flow passage may preferably bet formed by providing the pins on opposite sides of the integrated circuit during moulding.

In some embodiments, one or more of the pins may be in the form of a hollow tube. This allows suction to be applied to the external end of the hollow tube so as to hold the gel in place during the moulding process.

Whilst it is preferable to create the bores during moulding, it will be appreciated that as an alternative, the bores can be created or modified mechanically after the encapsulated circuit is removed from the mould tool. In this latter case, the bores can be formed in any suitable manner as desired or as appropriate.

According to a second aspect of the present invention there is provided an encapsulated integrated circuit sensor manufactured in accordance with the method of the first aspect of the invention.

The invention will now be described further with reference to the accompanying drawing, the single of figure of which shows a schematic representation of an integrated circuit sensor in a mould tool at one stage during the method in accordance with the present invention.

In a conventional method of encapsulating semi conductor circuits, one or more integrated circuits are typically mounted on a metal carrier or paddle. The paddle can be formed as one piece or can comprise a plurality of electrically separate sections upon which different integrated circuits can be mounted. Electrical connections are then made to each integrated circuit by wire bonding between connection points on the respected integrated circuits and internal ends of metal pins that will form the external electrical connections to the encapsulated circuits when moulded. Electrical connections can also be made between respective integrated circuits by wire bonding between connecting points on each respective circuit.

The one or more integrated circuits are then potted or encapsulated in a plastic material using conventional injection-moulding techniques to form a single encapsulated integrated circuit.

However when such standard encapsulation techniques are used with chemical or biological sensors in a flow cell, it can be difficult to achieve this at low cost because of the difficulty in providing a means whereby flow of material over the encapsulated sensor is allowed.

Therefore, in the present invention, standard encapsulation techniques as described above have been modified to permit the encapsulation of integrated circuits including biological or chemical sensors in a flow cell which are designed to be sensitive to biological or chemical material, or indeed any other physical properties of substances and which can be carried out in a more cost efficient manner therefore allowing the production of relatively low-cost encapsulated sensors in a flow cell.

Thus, referring now to the figure, there is shown an integrated circuit 102 which includes a biological or chemical sensor (not shown). The integrated circuit 102 is mounted on a paddle 103 and electrical connections 104 from the integrated circuit 102 to any other integrated circuits, if any, being encapsulated along with circuit 102, are made in conventional manner. In the embodiment shown in the figure two further integrated circuits 106, 107 mounted on a single paddle 108 are provided and the integrated circuits 102, 106, 107 are connected by connections 104 and 109 respectively. It will therefore be appreciated that any number of integrated circuits can be used and these may be mounted on as many or few paddles as desired or as appropriate.

The integrated circuit 102 containing the sensor is then covered with a quantity of a gel material 111, a suitable gel being for example that manufactured by Dow Corning, and identified as Hipec - 9224 gel, so as to at least cover the sensor of the integrated circuit 102. The gel covered integrated circuit 102, along with any other integrated circuits connected thereto for example integrated circuits 106, 107 of the figure are then placed into a cavity 112 of a plastic moulding tool. As an alternative to the above, the gel material 111 can be applied to the integrated circuit 102 containing the sensor after the paddle or paddles 103, 108 has been placed in the plastic moulding tool.

Two or more pins 113 are provided which extend from a position substantially in contact with the surface of the gel 111 covering at least the sensor of integrated circuit 102, to a position external of the mould cavity 112. Preferably, each pin 113 is formed as an integral part of the moulding tool, although one or more pins 113 formed separately from the tool may be used as desired or appropriate. In one embodiment, each pin 113 is retractable and is arranged to be long enough to make contact with the quantity of gel 109 when the pin is extended, and to retract into the body of the mould tool when retracted.

A plastic maternal is then injected- (hot and under pressure) via an injection hole 114 in the tool in the conventional manner and fills the cavity 112. After mouldings of the pins 113 are retractable, the pins 101 are withdrawn sufficiently to clear the cavity 106 and the encapsulated circuit is ejected from the tool cavity 112 and is ready for testing. If the pins 113 are fixed, each pin 113 is removed by removing or separating the moulding tool in the area including the pin 101 or in any other manner as desired or as appropriate and the pins 113 are then removed. Once the pins 113 are removed, the resulting encapsulated circuit includes at least two bores or passageways through the plastic encapsulant which permit the gel 111 covering the sensor to be exposed to the atmosphere. In order to allow the biological or chemical sensor mounted on the integrated circuit 102 to operate the gel is removed either mechanically, by dissolving or washing away, or by being sucked out. The bores, together with the cavity formed by the removal of the gel, define a flow passage in the plastic encapsulant after moulding, which allows for the flow of air or gas to be sensed for biological or chemical matter to pass across the surface of the integrated circuit 102 and to be detected by the sensor.

The sensor may in some embodiments be a sensor comprising a reactive substance provided on integrated circuit 102, the reactive substance reacting with particular biological or chemical elements in the air, the reaction being detected by the integrated circuit 102 and thus indicating the presence of the particular biological or chemical element. Such sensors typically require activation before use by an activating substance or activating means. Suitable activating substances include the reactive substance itself, or catalysts which enable or speed up the reaction. In some cases, a protective layer is provided over the reactive substance or solvent for protection during the encapsulation process. In such cases the activating substance may be a solvent which dissolves or washes away the protective layer. The protective layer can alternatively be removed mechanically if desired. Activation of such a sensor can be performed directly after the gel is removed from the bore or directly before the sensor is to be used or at any convenient time between these two events.

Some sensors are designed to operate with the air or gas flow passing through one or more orifices in the sensors themselves and such sensors can include micro-machined silicon integrated circuits (not shown) that detect variations in speed of sound through a gaseous sample as an indication of the presence of contaminants. It will be appreciated that the method of the present invention can be used with such sensors.

Furthermore, in an alternative embodiment of the sensor, the flow of air or gas is arranged to be through a first bore in the encapsulant on a first side of the integrated circuit 102, through one or more orifices in the sensor, through an orifice in the paddle 103, carrying the integrated circuit and through a second bore in the encapsulant on a second side of the integrated circuit. In these circumstances, the flow passage can be formed by providing the pins 113 on opposite sides of the integrated circuit 102 during moulding allowing such a sensor to be used in the method of the present invention.

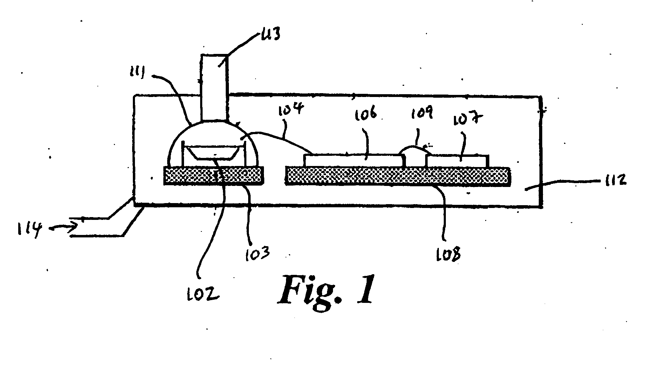

In the embodiment of the invention of figure 1, one or more additional integrated circuits 106, 107, are provided connected to the integrated circuit 102 containing the sensor. These additional circuits 106, 107 are encapsulated along with the integrated circuit 102. The additional integrated circuits 106, 107 may include, for example, signal processing circuitry, power generation circuitry, power supply circuitry, signal transmission and reception circuitry or any other circuitry which is necessary to ensure the correct operation of the sensor for any particular application.

It is envisaged that the pins 113 utilised in the method of the present invention will be either provided as a fixed part of the mould or as separate part which may be attached thereto. In the former case, the mould tool separation process can be arranged so that the direction of separation extracts the pins 113 from the encapsulated integrate circuit without damage to the pin 113 or circuit 102. It is also possible for one or more of the pins 113 to be in the form of a hollow tube. This is advantageous because, during the moulding process there may be a tendency in some mould tool designs for the mould compound to move the top of the flexible gel material 111 too far so that it is no longer in contact with one or more pin 113. To overcome this, a small amount of suction can be applied to the external end of the hollow tube so as to hold the gel 111 to the end of the tube and prevent the tube 113 and gel 111 from becoming separated.

It should be appreciated that whilst the present invention is primarily a modification to conventional and well understood semi conducting encapsulation techniques, and as such many of the problems associated with such techniques have already been solved, the particular problem of producing a low-cost flow cell chemical or biological sensors in an encapsulated integrated circuit form has not hitherto been solved. The present invention provides a method of producing such sensors which are of relatively low cost.

It is of course to be understood that the invention is not intended to be restricted to the details of the above embodiments which are described by way of example only.

## Claims

1. A method of encapsulating an integrated circuit sensor comprising the following steps: -
Providing an integrated circuit including a biological or chemical sensor;
Applying a gel material to said circuit so as to substantially cover at least said sensor
Inserting said integrated circuit into a cavity of a moulding tool;
Mounting two or more pins relative to s aid circuit such that said pins extend substantially into contact with said gel covering said sensor;
Introducing a mould compound into said cavity whereby said integrated circuit and a part of said pins are encapsulated thereby;
Removing said pins to form bores extending through said moulded material to said gel; and
Removing substantially all of said gel material from the sensor so as to expose the sensor to the atmosphere via said bore.

2. A method as claimed in claim 1 wherein the gel is removed from the sensor mechanically.

3. A method as claimed in claim 2 wherein the gel is removed from the sensor by being dissolved or washed away.

4. A method as claimed in claim 3 wherein the gel is removed from the sensor by being sucked off.

5. A method as claimed in any preceding claim wherein one or more of the pins is in the form of a hollow tube allowing suction to be applied to the external end of the hollow tube, so as to hold the gel in place during the moulding process.

6. A method as claimed in any preceding claim wherein the bores, together witch the cavity formed by the removal of the gel, define a flow passage in the plastic encapsulant after moulding, which allows for a flow of air or gas to pass across the surface of the sensor and thereby for biological or chemical matter in the air or gas to be detected by the sensor.

7. A method as claimed in any preceding claim wherein the sensor is a sensor of the type comprising an reactive substance provided on a integrated circuit, the reactive substance reacting with particular biological or chemical elements in the air, the reaction being detected by the integrated circuit and thus indicating the presence of the particular biological or chemical element.

8. A method as claimed in claim 7 wherein the sensor requires activation before use.

9. A method as claimed, in claim 8 wherein activation of the sensor is achieved by addition of an activating substance.

10. A method as claimed in claim 9 wherein the activating substance is a catalyst.

11. A method as claimed in claim 10 wherein the activating substance is the reactive substance itself.

12. A method as claimed in claim 8 wherein a protective layer is provided over the reactive substance for protection during encapsulation.

13. A method as claimed in claim 12 wherein activation of the sensor is achieved by removal of the protective layer.

14. A method as claimed in claim 13 wherein the protective layer is removed by being dissolved or washed away.

15. A method as claimed in claim 14 wherein the protective layer is removed mechanically.

16. A method as claimed in any preceding claim wherein the sensor is a sensor of the type which is designed to operate with an air or gas fLow passing through one or more orifices in the sensor itself.

17. A method as claimed in claim 16 wherein the sensors comprises a micro-machined silicon integrated circuit that detect variations in speed of sound through a gaseous sample as an indication of the presence of contaminants.

18. A method as claimed in claim 16 or claim 17 wherein the flow of air or gas is arranged to be through a first bore in the encapsulant on a first side of the integrated circuit, through one or more orifices in the sensor, through an orifice in a paddle carrying the integrated circuit and through a second bore in the encapsulant on a second side of the integrated circuit.

19. A method as claimed in claim 18 wherein the flow passage is formed by providing the pins on opposite sides of the integrated circuit during moulding.

20. A method as claimed in any preceding claim wherein the integrated circuit including the chemical or biological sensor is mounted on a metal carrier or paddle.

21. A method as claimed in claim 20 wherein the paddle comprises a single piece.

22. A method as claimed in claim 21 wherein the paddle comprises a plurality of electrically separate sections upon which additional integrated circuits may be mounted.

23. A method as claimed in claim 22 wherein the additional integrated circuits are encapsulated along with the integrated circuit including the biological or chemical sensor.

24. A method as claimed in claim 23 wherein electrical connections are made to the or each integrated circuit by wire bonding between connection points on the respective integrated circuits and internal ends of metal pins that will form the external electrical connections to the encapsulated circuits when moulded.

25. A method as claimed in claim 24 wherein electrical connections are made between integrated circuits mounted on separate paddle sections by wire bonding between connecting points on the respective circuits.

26. An encapsulated integrated circuit sensor manufactured in accordance with the method of any preceding claim.

## Patentansprüche

1. Verfahren zum Einkapseln eines integrierten Schaltungssensors enthaltend die folgenden Schritte:
Vorsehen einer integrierten Schaltung mit einem biologischen oder chemischen Sensor;
Anbringen eines Gelmaterials auf die genannte Schaltung, um wenigstens den genannten Sensor im Wesentlichen abzudecken;
Einsetzen der genannten integrierten Schaltung in eine Aushöhlung eines Gießwerkzeuges;
Montieren von zwei oder mehreren Stiften relativ zu der Schaltung derart, dass sich die genannten Stifte im Wesentlichen in Berührung mit dem genannten Gel, welches den genannten Sensor bedeckt, erstrecken;
Einführen einer Formverbindung in die genannte Aushöhlung, wodurch die genannte integrierte Schaltung und ein Teil der genannten Stifte eingekapselt werden;
Entfernen der genannten Stifte, um Bohrungen zu bilden, welche sich durch das genannte geformte Material zu dem genannten Gel erstrecken; und
Entfernen von im Wesentlichen des gesamten genannten Gelmaterials von dem Sensor derart, dass der Sensor über die Bohrung der Atmosphäre ausgesetzt ist.

2. Verfahren nach Anspruch 1, bei welchem das Gel von dem Sensor mechanisch entfernt wird.

3. Verfahren nach Anspruch 2, bei welchem das Gel von dem Sensor gelöst oder weggewaschen wird.

4. Verfahren nach Anspruch 3, bei welchem das Gel von dem Sensor durch Absaugen entfernt wird.

5. Verfahren nach einem der vorhergehenden Ansprüche, bei welchem einer oder mehrere Stifte in der Form eines hohlen Rohres ist bzw. sind, welches ein Absaugen gestattet, welches an dem äußeren Ende des hohlen Rohres angewendet wird, um das Gel während des Formprozesses an Ort und Stelle zu halten.

6. Verfahren nach einem der vorhergehenden Ansprüche, bei welchem die Bohrungen, zusammen mit der Aushöhlung, welche durch Entfernen des Gels gebildet ist, einen Strömungsdurchgang in der Kunststoffeinkapselung nach der Formung definieren, welcher einen Luft- oder Gasstrom über die Oberfläche des Sensors zu passieren und **dadurch** biologisches oder chemisches Material in der Luft oder dem Gas durch den Sensor festgestellt zu werden gestattet.

7. Verfahren nach einem der vorhergehenden Ansprüche, bei welchem der Sensor ein Sensor des Typs ist, welcher eine reaktive Substanz auf einer integrierten Schaltung enthält, wobei die reaktive Substanz mit bestimmten biologischen oder chemischen Elementen in der Luft reagiert, wobei die Reaktion durch die integrierte Schaltung festgestellt und damit die Anwesenheit des bestimmten biologischen oder chemischen Elements angezeigt wird.

8. Verfahren nach Anspruch 7, bei welchem der Sensor eine Aktivierung vor der Benutzung erfordert.

9. Verfahren nach Anspruch 8, bei welchem eine Aktivierung des Sensors durch Hinzufügen einer aktivierenden Substanz erreicht wird.

10. Verfahren nach Anspruch 9, bei welchem die aktivierende Substanz ein Katalysator ist.

11. Verfahren nach Anspruch 10, bei welchem die aktivierende Substanz die reaktive Substanz selbst ist.

12. Verfahren nach Anspruch 8, bei welchem eine schützende Schicht über der reaktiven Substanz zum Schutz während einer Einkapselung vorgesehen ist.

13. Verfahren nach Anspruch 12, bei welchem die Aktivierung des Sensors durch Entfernen der schützenden Schicht erreicht wird.

14. Verfahren nach Anspruch 13, bei welchem die schützenden Schicht entfernt wird, indem sie gelöst oder weggewaschen wird.

15. Verfahren nach Anspruch 14, bei welchem die schützende Schicht mechanisch entfernt wird.

16. Verfahren nach einem der vorhergehenden Ansprüche, bei welchem der Sensor ein Sensor des Typs ist, welcher gestaltet ist, um mit einem Luft- oder Gasstrom zusammenzuwirken, welcher durch eine oder mehrere Öffnungen in dem Sensor selbst hindurchgelangt.

17. Verfahren nach Anspruch 16, bei welchem die Sensoren eine mikrobearbeitete integrierte Silikonschaltung aufweisen, welche Veränderungen in der Geschwindigkeit des Schalls durch eine gasförmige Probe als Anzeichen für die Anwesenheit von Kontaminanten feststellt.

18. Verfahren nach Anspruch 16 oder 17, bei welchem die Strömung von Luft oder Gas so eingerichtet ist, dass sie durch eine erste Bohrung in der Einkapselung auf einer ersten Seite der integrierten Schaltung, durch eine oder mehrere Öffnungen in dem Sensor, durch eine Öffnung in einem Paddel, welches die integrierte Schaltung trägt, und durch eine zweite Bohrung, in der Einkapselung auf einer zweiten Seite der integrierten Schaltung gelangt.

19. Verfahren nach Anspruch 18, bei welchem der Strömungsdurchgang gebildet wird, indem die Stifte auf einander gegenüberliegenden Seiten der integrierten Schaltung während der Formung vorgesehen werden.

20. Verfahren nach einem der vorhergehenden Ansprüche, bei welchem die integrierte Schaltung einschließlich des chemischen oder biologischen Sensors auf einem Metallträger oder einem Paddel montiert ist.

21. Verfahren nach Anspruch 20, bei welchem das Paddel ein einziges Teil umfasst.

22. Verfahren nach Anspruch 21, bei welchem das Paddel eine Vielzahl von elektrisch getrennten Abschnitten aufweist, auf welchen zusätzliche integrierte Schaltungen montiert werden können.

23. Verfahren nach Anspruch 22, bei welchem die zusätzlichen integrierten Schaltungen zusammen mit der integrierten Schaltung, welche den biologischen oder chemischen Sensors einschließt, eingekapselt werden.

24. Verfahren nach Anspruch 23, bei welchem elektrische Verbindungen zu der oder jeder integrierten Schaltung gemacht werden, indem zwischen Verbindungspunkten an den jeweiligen integrierten Schaltungen und inneren Enden von Metallstiften, welche die externen elektrischen Verbindungen zu den eingekapselten Schaltkreisen, wenn sie geformt werden, Drahtverbindungen vorgesehen werden.

25. Verfahren nach Anspruch 24, bei welchem elektrische Verbindungen zwischen integrierten Schaltungen, welche auf separaten Paddelabschnitten montiert sind, durch Drahtverbindungen zwischen Verbindungspunkten auf den jeweiligen Schaltungen gemacht werden.

26. Eingekapselter integrierter Schaltungssensor hergestellt in Übereinstimmung mit dem Verfahren nach einem der vorhergehenden Ansprüche.

## Revendications

1. Procédé pour encapsuler un capteur de circuit intégré comprenant les étapes suivantes consistant à :
prévoir un circuit intégré comprenant un capteur biologique ou chimique,
appliquer un matériau en gel sur ledit circuit afin de recouvrir sensiblement au moins ledit capteur ;
insérer ledit circuit intégré dans une cavité d'un outil de moulage ;
monter deux broches ou plus par rapport audit circuit de sorte que lesdites broches s'étendent sensiblement en contact avec ledit gel recouvrant ledit capteur ;
introduire un composé de moule dans ladite cavité, moyennant quoi ledit circuit intégré et une partie desdites broches sont encapsulés ainsi ;
retirer lesdites broches pour former des alésages s'étendant à travers ledit matériau moulé jusqu'audit gel ; et
retirer sensiblement tout le matériau en gel du capteur afin d'exposer le capteur à l'atmosphère via ledit alésage.

2. Procédé selon la revendication 1, dans lequel le gel est retiré du capteur mécaniquement.

3. Procédé selon la revendication 2, dans lequel le gel est retiré du capteur en étant dissous ou lavé.

4. Procédé selon la revendication 3, dans lequel le gel est retiré du capteur en étant aspiré.

5. Procédé selon l'une quelconque des revendications précédentes, dans lequel une ou plusieurs des broches se présentent sous la forme d'un tube creux permettant d'appliquer l'aspiration sur l'extrémité externe du tube creux, afin de maintenir le gel en place pendant le procédé de moulage.

6. Procédé selon l'une quelconque des revendications précédentes, dans lequel les alésages, conjointement à la cavité formée par le retrait du gel, définissent un passage d'écoulement dans l'élément encapsulant en plastique après le moulage, qui permet à un écoulement d'air ou de gaz de passer sur la surface du capteur et ainsi pour la matière biologique ou chimique dans l'air ou le gaz, d'être détectée par le capteur.

7. Procédé selon l'une quelconque des revendications précédentes, dans lequel le capteur est un capteur du type comprenant une substance réactive prévue sur un circuit intégré, la substance réactive réagissant avec des éléments biologiques ou chimiques particuliers dans l'air, la réaction étant détectée par le circuit intégré et indiquant ainsi la présence de l'élément biologique ou chimique particulier.

8. Procédé selon la revendication 7, dans lequel le capteur nécessite une activation avant l'usage.

9. Procédé selon la revendication 8, dans lequel l'activation du capteur est obtenue en ajoutant une substance d'activation.

10. Procédé selon la revendication 9, dans lequel la substance d'activation est un catalyseur.

11. Procédé selon la revendication 10, dans lequel la substance d'activation est la substance réactive elle-même.

12. Procédé selon la revendication 8, dans lequel une couche de protection est prévue sur la substance réactive pour la protection pendant l'encapsulation.

13. Procédé selon la revendication 12, dans lequel l'activation du capteur est obtenue en retirant la couche de protection.

14. Procédé selon la revendication 13, dans lequel la couche de protection est retirée en étant dissoute ou lavée.

15. Procédé selon la revendication 14, dans lequel la couche de protection est retirée mécaniquement.

16. Procédé selon l'une quelconque des revendications précédentes, dans lequel le capteur est un capteur de type qui est conçu pour fonctionner avec un écoulement d'air ou de gaz passant à travers un ou plusieurs orifices dans le capteur lui-même.

17. Procédé selon la revendication 16, dans lequel le capteur comprend un circuit intégré en silicium micro-usiné qui détecte les variations de la vitesse du son à travers un échantillon gazeux en tant qu'indication de la présence de contaminants.

18. Procédé selon la revendication 16 ou 17, dans lequel l'écoulement d'air ou de gaz est agencé pour avoir lieu à travers un premier alésage dans l'élément d'encapsulation sur un premier coté du circuit intégré, à travers un ou plusieurs orifices dans le capteur, à travers un orifice dans la palette transportant le circuit intégré et à travers un second alésage dans l'élément d'encapsulation sur un second côté du circuit intégré.

19. Procédé selon la revendication 18, dans lequel le passage d'écoulement est formé en prévoyant les broches sur les côtés opposés du circuit intégré pendant le moulage.

20. Procédé selon l'une quelconque des revendications précédentes, dans lequel le circuit intégré comprenant le capteur chimique ou biologique est monté sur un support métallique ou palette.

21. Procédé selon la revendication 20, dans lequel la palette comprend une seule pièce.

22. Procédé selon la revendication 21, dans lequel la palette comprend une pluralité de sections électriquement séparées sur lesquelles des circuits intégrés supplémentaires peuvent être montés.

23. Procédé selon la revendication 22, dans lequel les circuits intégrés supplémentaires sont encapsulés conjointement au circuit intégré comprenant le capteur biologique ou chimique.

24. Procédé selon la revendication 23, dans lequel les raccordements électriques sont réalisés par rapport au circuit intégré ou à chaque circuit intégré par une liaison par fil entre les points de raccordement sur des circuits intégrés respectifs et les extrémités internes des broches métalliques qui forment les raccordements électriques externes par rapport aux circuits encapsulés lorsqu'ils sont moulés.

25. Procédé selon la revendication 24, dans lequel les raccordements électriques sont réalisés entre les circuits intégrés montés sur des sections de palette séparées par une liaison de fil entre les points de raccordement sur les circuits respectifs.

26. Capteur de circuit intégré encapsulé fabriqué selon le procédé selon l'une quelconque des revendications précédentes.
